Europäisches Patentamt

European Patent Office

Office européen des brevets

(11) Publication number: **0 341 501**
**A2**

## (12) EUROPEAN PATENT APPLICATION

(21) Application number: 89107642.4

(51) Int. Cl.4: **H01L 39/24**

(22) Date of filing: 27.04.89

(30) Priority: 07.05.88 JP 110890/88

(43) Date of publication of application:
15.11.89 Bulletin 89/46

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Morohashi, Shin'ichi Fujitsu Limited
Patent Department 1015 Kamikodanaka
Nakahara-ku Kawasaki-shi Kanagawa 211(JP)
Inventor: Yoneda, Yasuhiro Fujitsu Limited
Patent Department 1015 Kamikodanaka
Nakahara-ku Kawasaki-shi Kanagawa 211(JP)

(74) Representative: Sunderland, James Harry et al
HASELTINE LAKE & CO Hazlitt House 28
Southampton Buildings Chancery Lane
London WC2A 1AT(GB)

(54) Methods of forming passivation films on superconductors.

(57) A fluorocarbon resin passivation film is formed on a ceramic superconductor by applying either an ion plating method or a dual ion beam sputtering method, using a solid as a source material.

In the ion plating method, evaporated tetrafluoroethylene, for example, is ionised and accelerated so as to attain an ion beam energy of 1 to 10 KeV by which a polytetrafluoroethylene film is formed on the ceramic superconductor, and in the dual ion beam sputtering method, a sputtered tetrafluoroethylene ion beam, for example, forms a polytetrafluoroethylene film on the ceramic superconductor, assisted by an argon ion beam, for example, having ion energy of 1 to 10 KeV.

## Methods of forming passivation films on superconductors.

The present invention relates to methods of forming passivation films on superconductors.

The superconduction characteristics of a superconductor may be referred to as "superconductivity" and are represented by a critical temperature (Tc) and a resistivity of the superconductor. As is well known, for a superconductor, it is desirable that its resistivity at room temperature be low and its Tc value be high. Usually, for a superconductor, its resistivity at room temperature is sufficiently low, but its Tc value is also low, as low as liquid helium temperatures. This has been an obstacle in the way of advances in the practical application of superconductors. However, since the discovery of ceramic superconductors, there has been renewed study of superconductors, because ceramic superconductors can have very high Tc values, higher than liquid nitrogen temperatures.

It has been found that ceramic superconductors are greatly affected by humidity and water, in such a way that their Tc values decrease and room temperature resistivities increase. This has been a serious problem for the practical use of ceramic superconductors and also for the fabrication of cryoelectronic devices including ceramic superconductor layers, such as Josephson junction devices, integrated circuit devices and superconducting quantum interference devices (SQUIDs). In the fabrication of such cryoelectronic devices, deterioration of superconductivity occurs when a semi-manufactured cryoelectronic device, including a ceramic superconductor layer, is annealed in air and/or soaked in water.

The problem described above, relating to ceramic superconductors, is essentially solved by forming a plasma polymerised passivation film on a surface of a ceramic superconductor layer, using an ion plating method (which is also known as a plasma discharging method). U.S. Patent Application No. 313 767, filed on 22nd February 1989, entitled "A Superconductor Passivated by an Organic Film and a Method for Forming the Organic Film" contains disclosure relating to such a plasma polymerised passivation film. The U.S. patent application will be called "Ref. (1)" hereinafter. Attention is also directed to European Patent Application No. 89103217.9, called "Ref. (2)" hereinafter. The disclosures of these documents are incorporated herein by reference.

The present invention relates to methods of forming an organic passivation film or a polymerised passivation film on a surface of a ceramic superconductor layer, for example for use in a cryoelectronic device. The polymerised passivation film is provided for preventing deterioration of superconduction characteristics of the ceramic superconductor occurring due to humidity and water around the ceramic superconductor layer.

According to Ref. (1), a polymerised passivation film is obtained using an ion plating method performed with a plasma discharging apparatus. In this method, only fluorocarbon compound gases such as trifluoromethane ($CHF_3$) are used as source material.

The restrictions or limited range of choices thus offered (that only a gas is to be used as the source material for performing the ion plating method and that only an ion plating method is to be applied for forming the polymerised passivation film) represent a disadvantage and inconvenience.

Embodiments of the present invention provide an extension of the range of choice of source materials to be used in an ion plating method for fabricating a passivation film on a ceramic superconductor layer, for example included in the cryoelectronic device.

Embodiments of the present invention also provide an extension of the range of choice of methods to be used for fabricating a passivation film on a ceramic superconductor layer, for example included in a cryoelectronic device.

Embodiments of the present invention are provided which offer two different methods for forming a polymerised passivation film on a ceramic superconductor layer, differing from the ion plating method of Ref. (1) using only a gas as the source material.

One of the two methods is an ion plating method using a solid instead of a gas. Such an ion plating method, embodying the present invention, will be called a "solid source method" hereinafter, as compared with a "gas source method" which refers to an ion plating method of Ref. (1), using a gas.

In a "solid source method" embodying the present invention, a fluorocarbon resin in a solid state, such as polytetrafluoroethylene ($CF_2:CF_2)_n$ is used as a source material. The solid source is put into a crucible provided in a chamber of an ion plating apparatus (which may otherwise be conventional), which is equivalent to a plasma discharging apparatus, and is evaporated by heating the crucible. The evaporated polytetrafluoroethylene, arriving at a plasma discharging region in the chamber, is first partially decomposed to monomers. The decomposed monomers are repolymerised into fluorocarbon resin and deposited on a surface of a ceramic superconductor (e.g. a ceramic superconductor layer) previously placed on an electrode in the chamber, as a plasma polymerised passivation film.

A plasma polymerised passivation film (fluorocarbon resin film) fabricated in this way has properties similar to those of the plasma polymerised film fabricated with a gas source method as disclosed in Ref. (1). The superconductivity of the ceramic superconductor layer coated with the fluorocarbon resin film, fabricated by the "solid source method" thereon, is not influenced by annealing in air and/or soaking in water. Further, a uniform and thin film less than 3 nm in thickness can be formed on a ceramic superconductor by the solid source method, as with the gas source method. This uniform and thin film can be used as a barrier layer of a Josephson junction device for instance

The other of the two methods is a dual ion beam sputtering method performed by using a dual ion beam sputtering apparatus. In a dual ion beam sputtering method embodying the present invention, a solid source is also used. The dual ion beam sputtering apparatus may be otherwise convention. That is, a sputtered fluorocarbon resin produced by an argon ion beam impinging on solid fluorocarbon resin provided as a solid source target is used, instead of the evaporated fluorocarbon resin produced as in the solid source method described above. Then, the sputtered fluorocarbon resin is assisted by another accelerated argon ion beam and deposited on a surface of a ceramic superconductor layer.

The fluorocarbon resin film fabricated on the ceramic superconductor with this dual ion beam sputtering method has properties similar to those of the fluorocarbon resin film fabricated by the solid source method.

Thus, the range of choice of source materials which can be used for ion plating is extended to include solid sources, and the range of choice of methods for fabricating a polymerised passivation film on to a ceramic superconductor layer is extended to include a dual ion beam sputtering method.

Reference is made, by way of example, to the accompanying drawings, in which:-

Fig. 1 is a schematic diagram of a vacuum chamber of an ion plating apparatus used for fabricating a fluorocarbon resin passivation film in accordance with a method embodying the present invention;

Fig. 2 is a schematic diagram of a vacuum chamber of a dual ion beam sputtering apparatus used for fabricating a fluorocarbon resin passivation film in accordance with a method embodying the present invention;

Fig. 3(a) is a schematic cross-sectional view of a sample having a ceramic superconductor ($YBaCuO_x$) layer formed on a substrate ($SrTiO_3$) and coated by a polytetrafluoroethylene film, for illustrating an initial step of a patterning process;

Fig. 3(b) is a schematic cross-sectional view of the sample with a resist film coated on the plasma polymerised film shown in Fig 3(a);

Fig. 3(c) is a schematic cross-sectional view of the sample with the resist shown in Fig. 3(b) being patterned;

Fig. 3(d) is a schematic cross-sectional view of the sample shown in Fig. 3(c) after patterning;

Fig. 3(e) is a schematic cross-sectional view of the sample, illustrating pattern etching of the polytetrafluoroethylene film shown in Fig. 3(d), by an argon ion etching method;

Fig. 3(f) is a schematic cross-sectional view of the sample, illustrating pattern etching of the $YBaCuO_x$ layer shown in Fig. 3(e), by a reactive ion etching method;

Fig. 3(g) is a schematic cross-sectional view of the patterned $YBaCuO_x$ layer, illustrating removal of the resist film and the polytetrafluoroethylene film in Fig. 3(f);

Fig. 3(h) is a schematic cross-sectional view of the sample with a polytetrafluoroethylene film coated on the patterned $YBaCuO_x$ layer shown in Fig. 3(g); and

Fig. 3(i) is a schematic cross-sectional view of the sample with an $SiO_2$ film coated on the polytetrafluoroethylene film shown in Fig. 3(h).

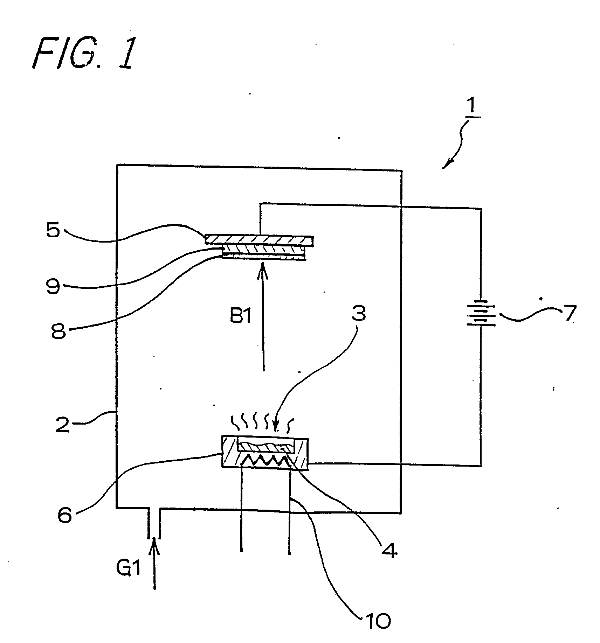

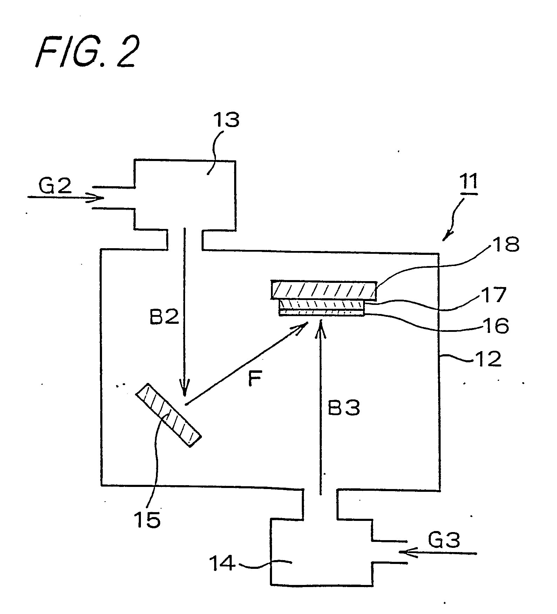

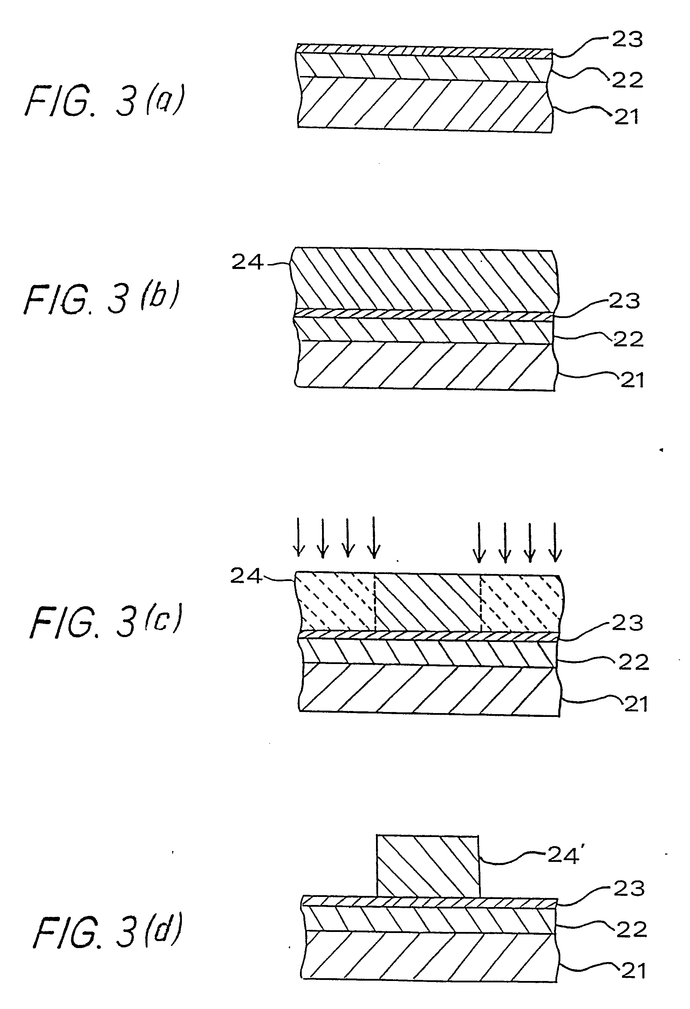

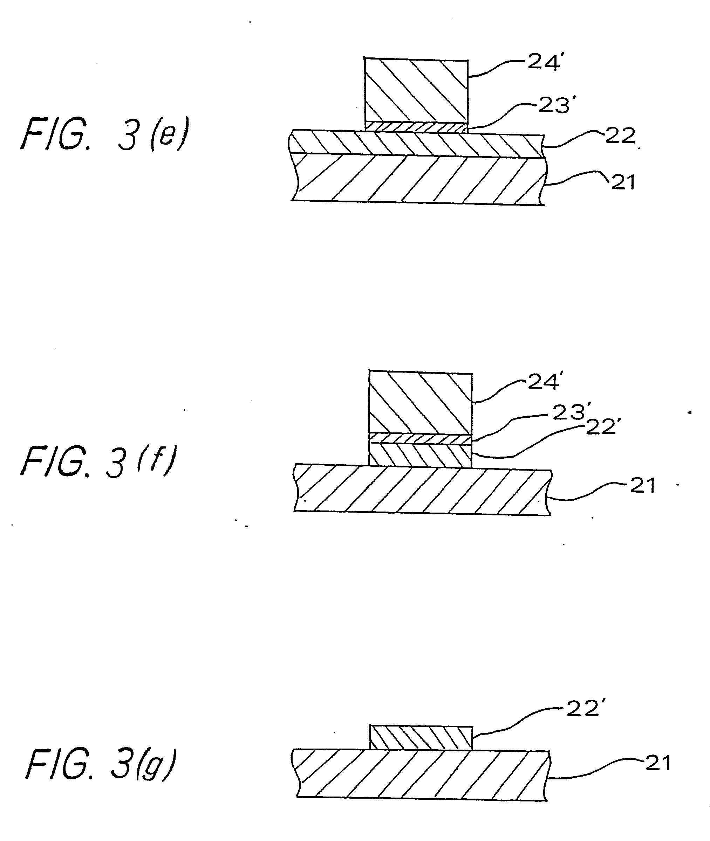

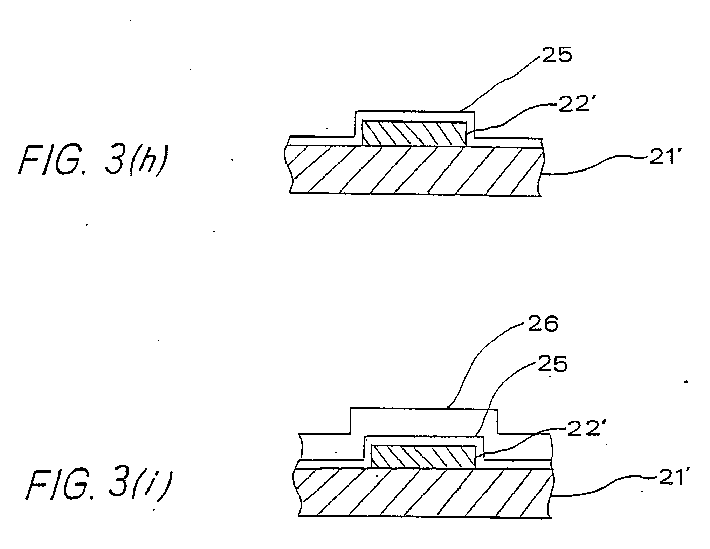

An embodiment of the present invention using a "solid source method" for forming a plasma polymerised passivation film on a ceramic superconductor layer will be described as a first embodiment with reference to Fig. 1. An embodiment of the present invention using a dual ion beam sputtering method for forming a polymerised passivation film on a ceramic superconductor will be described as a second embodiment with reference to Fig. 2. An embodiment of the present invention in which an integrated circuit device including a ceramic superconductor layer passivated by a polymerised passivation film is fabricated, using the solid source method, will be described as a third embodiment with reference to Figs. 3

FIRST EMBODIMENT

The first embodiment uses a "solid source method", which is an ion plating method using a solid as a source material, performed with a conventional ion plating apparatus schematically illustrated in Fig. 1. In Fig. 1, a vacuum chamber 2 of an ion plating apparatus 1 is first exhausted to 2.6

x $10^{-5}$ Pa (an exhausting outlet and an exhausting pump are not depicted in Fig 1) and an inert gas such as argon gas is introduced into the vacuum chamber 2 through an inlet, as indicated by an arrow G1 in Fig. 1. The pressure of argon gas is kept at about 5.3 x $10^{-2}$ Pa (4 x $10^{-2}$ to 7 x $10^{-2}$ Pa). An electrode 6 including a crucible 3 is provided in the vacuum chamber 2 in parallel with a target 5 so as to face towards the target 5. A solid source material 4 such as polytetrafluoroethylene is put in the crucible 3. A sample consisting of a substrate 9 made of strontium-titanium oxide ($SrTiO_3$) and a ceramic superconductor layer 8 made of yttrium-barium-copper ($YBaCuO_x$) formed on the $SrTiO_3$ substrate 9 is set on the target 5 so that a surface of the $YBaCuO_x$ layer 8 faces the electrode 6. Then a high voltage is applied between the target 5 and the electrode 6 from a power source 7, so that an argon plasma is generated in a space between the target 5 and the electrode 6. The crucible 3 is heated by a heater 10, and polytetrafluoroethylene in the crucible 3 is evaporated. As a result, the evaporated polytetrafluoroethylene is ionised and partially decomposed into monomers, by the argon plasma. The positively ionised tetrafluoroethylene polymers and monomers are accelerated by an electric field between the target 5 and the electrode 6, producing an ion beam B1 as shown in Fig. 1. The accelerated ion beam B1 impinges on the surface of the $YBaCuO_x$ layer 8 at the target 5, forming a plasma polymerised passivation film (fluorocarbon resin film) made of polytetrafluoroethylene on the surface of $YBaCuO_x$ layer 8.

In the method of this embodiment, it is important that the energy of the ion beam B1 is in the range 1 to 10 KeV. When the energy is larger than 10 KeV, the positively ionised elements of the tetrafluoroethylene polymers and monomers are implanted in the $YBaCuO_x$ layer 8, which does not result in formation of a uniform and thin film of polytetrafluoroethylene on the $YBaCuO_x$ layer 8. On the other hand, when the energy is smaller than 1 KeV, a sufficient adhesive strength cannot be provided for polytetrafluoroethylene film.

In the first embodiment, polytetrafluoroethylene is used as solid source material 4. However, the following other materials can be used as solid source materials for providing fluorocarbon resin films:-
tetrafluoroethylene-hexafluoropropylene copolymer,
tetrafluoroethylene-perfluoroalkylvinyl ether copolymer,
tetrafluoroethylene-hexafluoropropylene-perfluoroalkylvinyl ether copolymer,
ethylene-tetrafluoroethylene copolymer,
polychlorotrifluoroethylene,
ethylene-chlorotrifluoroethylene copolymer,
polyvinylidene fluoride, and
polyvinyl fluoride.

## SECOND EMBODIMENT

The second embodiment uses a dual ion beam sputtering method for forming a polymerised passivation film on a ceramic superconductor layer as schematically illustrated in Fig. 2. In Fig. 2, a vacuum chamber 12 of a dual ion beam sputtering apparatus 11 is kept at a vacuum of 1.3 x $10^{-2}$ Pa (an exhausting outlet and a vacuum pump are not depicted in Fig. 2). An inert gas such as argon is supplied to a plasma generating subchamber 13, as indicated by an arrow G2 in Fig. 2. The flow rate of the argon G2 is in the range 5 to 40 standard cubic centimetre per minute (SCCM). An argon ion beam B2 generated in the plasma generating subchamber 13 impinges on a target 15 made of fluorocarbon resin such as polytetrafluoroethylene, producing a sputtered beam F of tetrafluoroethylene. The energy of the argon ion beam B2 is in the range 20 to 600 eV, so that the sputtered beam F of tetrafluoroethylene from the target 15 is in a molecular state. The sputtered beam F impinges on a surface of a ceramic superconductor layer 16, for example a $YBaCuO_x$ layer, formed on a $SrTiO_3$ substrate 17 placed on another target 18.

On the other hand, an inert gas such as argon is supplied to another plasma generating subchamber 14 as indicated by an arrow G3. The flow rate of the argon flow G3 is in the range 5 to 40 SCCM. An argon ion beam B3 is generated in the plasma generating subchamber 14 and impinges on the surface of the $YBaCuO_x$ layer 16. The energy of the argon ion beam B3 is in the range 1 to 10 KeV The tetrafluoroethylene in the sputtered beam F is assisted by the argon ion beam B3, producing a repolymerised polytetrafluoroethylene film on the surface of the $YBaCuO_x$ layer 16 at a growth rate of 1 to 10 nm/min. In the above process, the temperature of the $YBaCuO_x$ layer does not exceed 400°C.

When the ion energy is larger than 10 KeV, the fluorine atoms in the sputtered polytetrafluoroethylene are implanted in the $YBaCuO_x$ layer. As a result, it is difficult to form a uniform and thin film of polytetrafluoroethylene. On the other hand, when the ion energy is smaller than 1 KeV, a sufficient adhesive strength cannot be provided for polytetrafluoroethylene film.

In the second embodiment, polytetrafluoroethylene is used as the target 15. However, other polyfluorocarbon resins can also be used. The materials mentioned above as solid source materials can be used.

As ceramic superconductor, $YBaCuO_x$ is used

in the above embodiments. However, other materials can be used instead of YBaCuO$_x$. The ceramic superconductors can be formed on an Al$_2$O$_3$ or MgO substrate instead of SrTiO$_3$.

In the second embodiment, the sputtered beam F from the target 15 is produced by irradiation with the argon ion beam B2 as shown in Fig. 2. However, an electron beam can be used instead of argon ion beam B2.

THIRD EMBODIMENT

The third embodiment relates to an application of a solid source method to a fabrication process for producing an integrated circuit device including ceramic superconductor layers. The solid source method is applied to the formation of polymerised passivation films on ceramic superconductor layers in the integrated circuit device. The fabricating process, including the processes performed by the solid source method, is illustrated through Figs. 3-(a) to 3(i).

In Fig. 3(a), a ceramic superconductor (YBaCuO$_x$) layer 22 is formed on a substrate (SrTiO$_3$) 21 by a conventional sputtering method. As substrate, Al$_2$O$_3$ or MgO could also be used. However, YBaCuO$_x$ superconductor is usually formed on a SrTiO$_3$ substrate, whilst BiSrCaCuO$_x$ superconductor is usually formed on a MgO substrate, with a view to eliminating problems due to lattice mismatching. The thickness of the YBaCuO$_x$ layer 22 is for instance 100 to 200 nm. Then, a polytetrafluoroethylene film 23 is formed on the YBaCuO$_x$ layer 22 in the same way as described in relation to the first embodiment. The thickness of the polytetrafluoroethylene film 23 is controlled so as to be in a range from 0.5 to 100 nm by adjusting deposition rate and deposition time. Normally, the thickness will be set to 10 to 50 nm. A resist film 24 about 500 nm thick is coated on the surface of the polytetrafluoroethylene film 23, by a spinner, as shown in Fig. 3(b) and the resist film 14 is exposed through a photomask (not depicted) as indicated by arrows in Fig. 3(c). The exposed portion of the resist film is removed by a developer and then water is used for washing, producing a resist pattern 24$'$ as shown in Fig. 3(d). The process of developing the exposed resist is made possible because the polytetrafluoroethylene film 23 protects the ceramic superconductor layer 22 from water and acid such as the developer.

Then, the polytetrafluoroethylene film 23 is pattern-etched by the conventional argon ion etching technique, using the resist film 24$'$ as a mask. The argon ion etching is performed by using a plasma generating apparatus under conditions such as, for example, pressure of argon 1.3 Pa and RF power in the range 1.3 to 2.6 W/cm$^2$. A pattern-etched polytetrafluoroethylene film 23$'$ fabricated by the argon ion technique described above is shown in Fig. 3(e).

Next, the YBaCuO$_x$ layer 22 is pattern-etched by a conventional reactive ion etching technique, using tetrachloromethane (CCl$_4$). The reactive ion etching is performed under conditions such that, for example, the pressure of the CCl$_4$ is 6.5 Pa and RF power is in the range 0.3 to 0.6 W/cm$^2$. A pattern-etched YBaCuO$_x$ layer 22$'$ is shown in Fig. 3(f).

The pattern-etched resist film 24$'$ and the pattern-etched polytetrafluoroethylene film 23$'$ are removed by applying oxygen plasma ashing and argon ion etching respectively, leaving the patterned YBaCuO$_x$ layer 22$'$. The oxygen plasma ashing is performed under a condition that the pressure of the oxygen is 13 Pa and the RF power is in the range 0.3 to 0.6 W/cm$^2$. Thus, the patterning of the YBaCuO$_x$ layer is accomplished as shown in Fig. 3(g).

A polytetrafluoroethylene film 25 is formed on the patterned YBaCuO$_x$ layer 22$'$ and partly on the substrate 21, in the same way as described in relation to the first embodiment. The thickness of the polytetrafluoroethylene film 25 is in the range 10 to 50 nm. The patterned YBaCuO$_x$ layer 22$'$ is protected by the polytetrafluoroethylene film 25 from humidity in the atmosphere, as shown in Fig. 3(h).

Usually, a thick silicon dioxide (SiO$_2$) film 26 is formed on the polytetrafluoroethylene film 25 by a conventional sputtering method. A typical thickness of the SiO$_2$ film 26 is 500 nm. This is shown in Fig. 3(i).

In the third embodiment, the solid source method is applied; however, a dual ion beam sputtering method, for example as used in the second embodiment, can also be applied.

In embodiments of the present invention, a fluorocarbon resin passivation film is formed on a ceramic superconductor by applying either an ion plating method or a dual ion beam sputtering method, using a solid as a source material. In the ion plating method, evaporated tetrafluoroethylene, for example, is ionised and accelerated so as to attain an ion beam energy of 1 to 10 KeV by which a polytetrafluoroethylene film is formed on the ceramic superconductor, and in the dual ion beam sputtering method, a sputtered tetrafluoroethylene ion beam, for example, forms a polytetrafluoroethylene film on the ceramic superconductor, assisted by an argon ion beam, for example, having ion energy of 1 to 10 KeV. Either of these methods can be applied in a process for forming a fluorocarbon resin film on a patterned ceramic superconductor layer in a cryoelectronic device.

## Claims

1. A method of forming a fluorocarbon resin film on a ceramic superconductor, said method comprising the steps of:-
generating a plasma of an inert gas;
evaporating a solid fluorocarbon resin for producing evaporated fluorocarbon resin;
generating an ion beam having an ion energy in the range 1 to 10 KeV (said ion energy being chosen in consideration of interaction between the inert gas plasma and the evaporated fluorocarbon resin); and
irradiating the ion beam on to a surface of the ceramic superconductor.

2. A method according to claim 1, wherein:-
said step of generating the plasma of the inert gas is performed by applying a high voltage to the inert gas;
said step of evaporating the solid fluorocarbon resin is performed by heating the solid fluorocarbon resin; and
said step of irradiating the ion beam on to the surface of the ceramic superconductor is performed by applying an electric field to the ion beam.

3. A method according to claim 1 or 2, wherein the inert gas used is an argon gas having a pressure of $4 \times 10^{-2}$ Pa to $7 \times 10^{-2}$ Pa.

4. A method according to claim 1, 2 or 3, wherein the fluorocarbon resin is a fluorocarbon resin selected from a group consisting of:-
polytetrafluoroethylene,
tetrafluoroethylene-hexafluoropropylene copolymer,
tetrafluoroethylene-perfluoroalkylvinyl ether copolymer,
tetrafluoroethylene-hexafluoropropylene-perfluoroalkylvinyl ether copolymer,
ethylene-tetrafluoroethylene copolymer,
polychlorotrifluoroethylene,
ethylene-chlorotrifluoroethylene copolymer,
polyvinylidene fluoride, and
polyvinyl fluoride.

5. A method of fabricating a fluorocarbon resin film on a ceramic superconductor, said method comprising the steps of:-
generating a first inert gas ion beam;
irradiating the first inert gas ion beam on to a target made of fluorocarbon resin, for producing a first sputtered beam of the fluorocarbon resin;
irradiating the first sputtered beam on to a surface of the ceramic superconductor;
generating a second inert gas ion beam having an ion energy of 1 to 10 KeV; and
irradiating the second inert gas ion beam on to the surface of the ceramic superconductor for assisting the first sputtered beam to produce a repolymerised film therefrom at the surface of the ceramic superconductor.

6. A method according to claim 5, wherein the first inert gas ion beam has an ion energy of 20 to 600 eV.

7. A method according to claim 5 or 6, wherein the first inert gas and the second inert gas are argon gas

8. A method according to claim 5, wherein the target made of fluorocarbon resin is performed by using a target made of fluorocarbon resin selected from a group consisting of:-
polytetrafluoroethylene,
tetrafluoroethylene-hexafluoropropylene copolymer,
tetrafluoroethylene-perfluoroalkylvinyl ether copolymer,
tetrafluoroethylene-hexafluoropropylene-perfluoroalkylvinyl ether copolymer,
ethylene-tetrafluoroethylene copolymer,
polychlorotrifluoroethylene,
ethylene-chlorotrifluoroethylene copolymer,
polyvinylidene fluoride, and
polyvinyl fluoride

# FIG. 1

*FIG. 2*

*FIG. 3 (a)*

23
22
21

*FIG. 3 (b)*

24
23
22
21

*FIG. 3 (c)*

24
23
22
21

*FIG. 3 (d)*

24'
23
22
21

FIG. 3 (e)

24'
23'
22
21

FIG. 3 (f)

24'
23'
22'
21

FIG. 3(g)

22'
21

FIG. 3(h)

FIG. 3(i)